# EUROPÄISCHE PATENTSCHRIFT

(11) **EP 1 336 283 B1**
(45) Veröffentlichungstag und Bekanntmachung des Hinweises auf die Patenterteilung: **23.07.2008**
(21) Anmeldenummer: 01994011.3
(22) Anmeldetag: 31.10.2001
(51) Int. Cl.: H04L 25/49, H04L 27/34, H03M 13/25, H04L 1/00

(54) **VERFAHREN ZUR CODIERTEN MODULATION MIT BERÜCKSICHTIGUNG VON TAIL-BITS UND DEREN CODIERUNG**
CODED MODULATION METHOD, WHICH TAKES TAILBITS AND THEIR CODING INTO ACCOUNT
PROCEDE DE MODULATION CODEE PRENANT COMPTE DES BITS DE QUEUE ET DE LEUR ENCODAGE

(30) Priorität: 07.11.2000 DE 10065919
(43) Veröffentlichungstag der Anmeldung: 20.08.2003
(73) Patentinhaber: ROBERT BOSCH GMBH, 70442 Stuttgart (DE)
(72) Erfinder: HOFMANN, Frank, 31139 Hildesheim (DE)
(86) Internationale Anmeldenummer: PCT/DE2001/004124
(87) Internationale Veröffentlichungsnummer: WO 2002/039690

(56) Entgegenhaltungen:
- WO-A-98/43383
- US-A- 4 908 827
- US-A- 5 812 601
- IMAI H ET AL: "A NEW MULTILEVEL CODING METHOD USING ERROR-CORRECTING CODES" IEEE TRANSACTIONS ON INFORMATION THEORY, IEEE INC. NEW YORK, US, Bd. IT-23, Nr. 3, 1977, Seiten 371-377, XP000760819 ISSN: 0018-9448
- JUNG-FU CHENG ET AL: "Complexity-reduced multilevel coding with rate-compatible punctured convolutional codes" GLOBAL TELECOMMUNICATIONS CONFERENCE, 1993, INCLUDING A COMMUNICATIONS THEORY MINI-CONFERENCE. TECHNICAL PROGRAM CONFERENCE RECORD, IEEE IN HOUSTON. GLOBECOM '93., IEEE HOUSTON, TX, USA 29 NOV.-2 DEC. 1993, NEW YORK, NY, USA,IEEE, 29. November 1993 (1993-11-29), Seiten 814-818, XP010109772 ISBN: 0-7803-0917-0
- JARDAK H G ET AL: "Concatenated codes using multilevel structures for PSK signalling over the Rayleigh fading channel" IEE PROCEEDINGS: COMMUNICATIONS, INSTITUTION OF ELECTRICAL ENGINEERS, GB, Bd. 141, Nr. 4, 1. August 1994 (1994-08-01), Seiten 233-6, XP006001667 ISSN: 1350-2425
- HUBER J ET AL: "CODIERTE MODULATION MITTELS MULTILEVEL-CODES: ENTWICKLUNG UND AKTUELLER STAND DER FORSCHUNG" IT + TI INFORMATIONSTECHNIK UND TECHNISCHE INFORMATIK, OLDENBOURG VERLAG. MUNCHEN, DE, Bd. 41, Nr. 1, Februar 1999 (1999-02), Seiten 30-35, XP000833445 ISSN: 0944-2774
- YANG-GI KANG: "Pilot symbol assisted modulation using encoder tail bits" PERSONAL, INDOOR AND MOBILE RADIO COMMUNICATIONS, 1998. THE NINTH IEEE INTERNATIONAL SYMPOSIUM ON BOSTON, MA, USA 8-11 SEPT. 1998, NEW YORK, NY, USA,IEEE, US, 8. September 1998 (1998-09-08), Seiten 891-894, XP010314562 ISBN: 0-7803-4872-9

## Beschreibung

### Stand der Technik

Die Erfindung geht aus von einem Verfahren zur codierten Modulation nach der Gattung des unabhängigen Patentanspruchs.

Es ist bereits bekannt, eine codierte Modulation einzusetzen, bei der Kanalcodierung und Modulation gemeinsam optimiert werden. Äquivalent zu dem Begriff codierte Modulation ist auch die Bezeichnung Multilevel-Codierung bekannt.

Aus US 5,812,601 ist es bekannt Multilevel-Codierung mit punktierten Faltungscodes zu verwenden. Jeder der parallelen Datenströme kann dabei eine andere Coderate besitzen. Wenn der Code vom selben Muttercode abgeleitet wird, wird ein anders Punktierungsmuster verwendet. Aus Imai et al: "A New Multilevel Coding Method Using Error Correcting Codes", IEEE Transactions on Information Theory, IEEE Inc. New York, US, Bd. IT-23, Nr. 3, 1997, Seiten 371 - 377 erläutert das Prinzip der Multilevel-Codierung und das parallele Datenströme eines Multilevel-Codierers unterschiedliche Coderaten besitzen können. Aus US 4,908,827 ist es bereits bekannt, über eine Punktierung der Tailbits des einen Datenstroms einer Anpassung an eine vorgegebene Rahmenlänge zu erreichen.

### Vorteile der Erfindung

Das erfindungsgemäße Verfahren zur codierten Modulation mit den Merkmalen des unabhängigen Patentanspruchs hat demgegenüber den Vorteil, dass für die sogenannten Tailbits eine variable Coderate verwendet wird, die jeweils so eingestellt wird; dass die vorhandene Übertragungskapazität voll genutzt werden kann. Der verwendete Übertragungsrahmen gibt die maximale Anzahl der Modulationssymbole vor. Dies führt zu einer optimalen Kapazitätssteigerung im Vergleich zu bekannten Verfahren. Die Tailbits werden entweder in den Codierern oder im vorgeschalteten Bitmultiplexer ergänzt.

Weiterhin ist das erfindungsgemäße Verfahren flexibel einsetzbar, da verschiedene Übertragungsmodi mit unterschiedlichen Anzahlen von Modulationssymbolen verwendbar sind. Darüber hinaus ist keine zusätzliche Signalisierung vom Sender zum Empfänger notwendig. Schließlich ist auch die Implementierung des erfindungsgemäßen Verfahrens einfach, da keine zusätzliche Rechenleistung notwendig ist.

Es ist vorteilhaft, dass die variable Coderate durch eine variable Punktierung erreicht wird. Punktierung bedeutet, dass um eine größere Coderate zu erzielen, einige Bits nicht mit übertragen werden.

Durch die in den abhängigen Ansprüchen aufgeführten Maßnahmen und Weiterbildungen sind vorteilhafte Verbesserungen des im unabhängigen Patentanspruch angegebenen Verfahrens zur codierten Modulation möglich.

Es ist von Vorteil, dass die variablen Punktierungsschemata entweder in einer Tabelle im Sender und in den Empfängern abgespeichert ist oder über eine bekannte Rechenvorschrift berechnet werden, wobei die Rechenvorschrift dem Sender und den Empfängern bekannt ist.

Darüber hinaus ist es vorteilhaft, dass dem Empfänger die feste Coderate für die Nutzbits und eine vorgegebene Übertragungsrate signalisiert werden, so dass der Empfänger daraus die variablen Coderaten für die Tailbits ausrechnen kann, um sich auf die übertragenen Daten zu synchronisieren.

Darüber hinaus ist es von Vorteil, dass eine Faltungscodierung verwendet wird, die eine weit verbreitete Technik zur Kanalcodierung ist. Die Anzahl der codierten Bits berechnet sich dabei aus der Anzahl der Modulationssymbole multipliziert mit der Stufigkeit der Modulation m und dividiert durch die Anzahl n der Stufen. Damit wird die vorhandene Übertragungskapazität optimal ausgenutzt.

Weiterhin ist es von Vorteil, dass sowohl ein Sender und als auch ein Empfänger Mittel zur Durchführung des erfindungsgemäßen Verfahrens aufweisen.

### Zeichnung

Ausführungsbeispiele der Erfindung sind in der Zeichnung dargestellt und werden in der nachfolgenden Beschreibung näher erläutert. Es zeigt Figur 1 eine Partitionierung einer 4-ASK, Figur 2 ein Blockschaltbild des erfindungsgemäßen Sender, Figur 3 ein Blockschaltbild des erfindungsgemäßen Empfängers und Figur 4 ein Flußdiagramm des erfindungsgemäßen Verfahrens.

### Beschreibung

Das digitale Übertragungssystem Digital Radio Mondiale (DRM) für die Übertragungsbänder unterhalb 30 MHz wird zur Zeit entwickelt. Es wurde entschieden, dass als die Kanalcodierung eine Multilevel-Codierung (MLC) verwendet wird. Dabei werden die Kanalcodierung und die Modulation gemeinsam optimiert, weshalb man auch von codierter Modulation spricht. Kanalcodierung fügt den Daten Redundanz hinzu, anhand derer Übertragungsfehler erkannt und gegebenenfalls korrigiert werden können.

Bei einem höherstufigen Modulationsverfahren mit einer q-nären Signalkonstellation hat das Signalalphabet genau q Werte. Die Grundlage für die MLC bildet die Partitionierung des Signalalphabets in Teilmengen. Jedem Teilungsschritt wird eine Komponente des Adreßvektors der Signalraumdarstellung zugewiesen. Hierbei wird jede Komponente mit einem eigenen Code geschützt. Betrachtet man eine 2^{m}-stufige Signalkonstellation, ergibt sich eine Aufteilung in n Stufen, wenn m=n ist, entsprechend dem Adreßvektor c (=c₀, c_{1,} ..., cₙ₋₁). Die Stufigkeit m der Modulation ist beispielsweise nicht notwendigerweise gleich der Anzahl der Stufen, wenn eine 64-QAM (Quadraturamplitudenmodulation) eingesetzt wird.

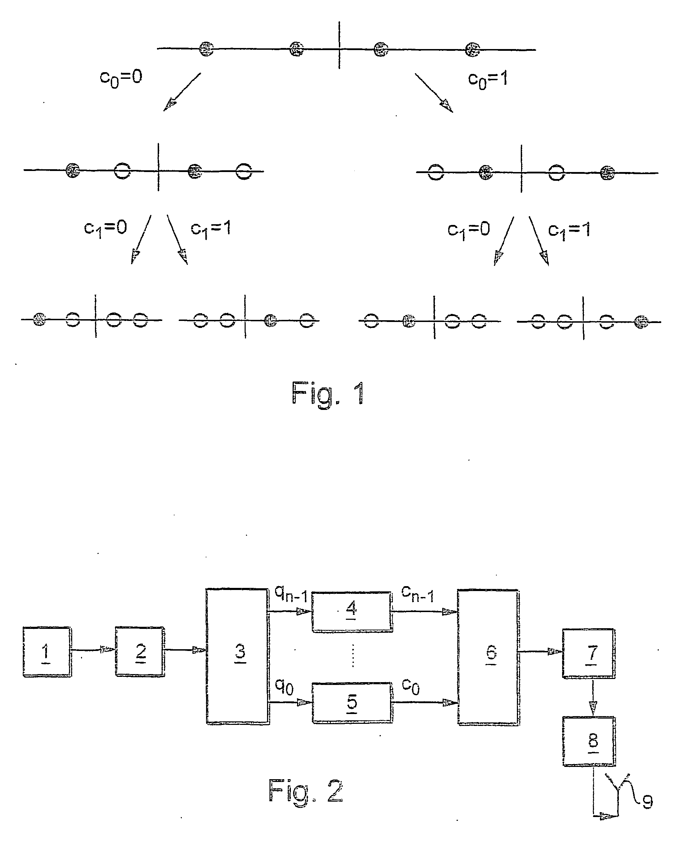

Figur 1 zeigt die Partitionierung einer 4-ASK (Amplitude Shift Keying = Amplitudenumtastung). Bei der 4-ASK werden also vier Zustände codiert. Die Codierung des Datenstroms erfolgt mit n parallelen Codierern, wobei der Code Co die kleinste Coderate R₀ aufweist, d.h. die meiste Redundanz zufügt und die fehleranfälligste Position des Adreßvektors schützt. In Figur 1 auf dem obersten Zustandsstrahl sind vier Zustände durch gefüllte Kreise markiert. Über die mittleren beiden Zustandsstrahle gelangt man dann zu den einzelnen codierbaren Zuständen bei einer 4-ASK. Der ersten Stufe wird entweder c₀ = 0 oder 1. Entsprechend werden die vier ausgefüllten Kreise auf zwei Zahlenstrahle verteilt, die zueinander komplementär ausgefüllte und leere Kreise aufweisen. Bei den unteren vier Zustandsstrahlen werden nun die einzelnen Zustände bei einer 4-ASK nämlich 00, 01, 10 und 11 codiert. Dabei weist der Zustand 00 ganz links einen ausgefüllten Kreis, der dann von drei leeren Kreisen gefolgt wird, auf. Der Zustand 01 weist ausgehend von links an der dritten Stelle den ausgefüllten Kreis auf. Der Zustand 10 weist ausgehend von links an der zweiten Stelle den ausgefüllten Kreis auf und der Zustand 11 weist ganz rechts den ausgefüllten Kreis auf. Die übrigen Positionen werden durch leere Kreise für eine 0 symbolisiert.

In Figur 2 ist ein Blockschaltbild des erfindungsgemäßen Senders dargestellt. Im Datenspeicher 1 sind Daten enthalten, die mit dem erfindungsgemäßen Sender zu versenden sind. Es sind hier jedoch auch andere Datenquellen nutzbar. Diese Daten werden von dem Datenspeicher 1 an einen Quellencodierer 2 übertragen, der eine Quellencodierung vornimmt, um die zu übertragenden Daten in der Menge zu reduzieren. Die so quellencodierten Daten mit den Nutzbits werden dann an einen Bitmultiplexer 3 übertragen, der den Datenstrom auf n parallele Leitungen verteilt. An jeder dieser n Leitungen, die mit 0 bis n-1 durchnumeriert werden, ist ein jeweiliger Codierer angeschlossen, der einen der Datenströme (q₀...qₙ₋₁) kanalcodiert. Beispielhaft ist hier ein Codierer 5 in der Leitung 0 und ein Codierer 4 in der Leitung n-1 dargestellt. Am Ausgang der jeweiligen Codierer liegen die Signale c₀ bzw. cₙ₋₁ vor. Die Codierer 4 und 5 führen die Kanalcodierung mittels einer Faltungscodierung durch und fügen damit den Nutzbits wieder Redundanz zu, wobei darüber hinaus an die Nutzbits sogenannte Tailbits angeschlossen werden, um die Codierer 4 und 5 als Faltungscodierer jeweils in einen definierten Endzustand zu überführen. Ein solcher Codierer 4 und 5 weist Schieberegister auf, die je nach Codierung verdrahtet sind. Die Tailbits, hier sind es logische Nullen, sorgen dafür, dass sich der Codierer 4 und 5 am Ende der Codierung und auch dann im Empfänger sich der Dekodierer am Ende der Dekodierung in einem definierten Zustand befinden, der daran erkannt wird, dass alle Bits im Codierer 4 und 5 bzw. Dekodierer logische Nullen sind.

Auch diese Tailbits werden mit einer Coderate beaufschlagt, die hier aber erfindungsgemäß variabel ist. Diese variable Coderate wird so eingestellt, dass die zur Verfügung stehende Übertragungskapazität, die durch die Übertragungsrahmen definiert ist, voll genutzt wird.

Variabel bedeutet hier, dass die Coderate der Tailbits für jede Stufe unterschiedlich sein kann. Durch die variable Anzahl von Tailbits erreicht man, dass die Anzahl der codierten Bits, das sind die codierten Nutzbits plus die codierten Tailbits, für jede Stufe des Codierungsschemas gleich ist. Darüber hinaus entspricht dann die Anzahl der codierten Bits der Anzahl der Modulationssymbole multipliziert mit der Stufigkeit der Modulation m und dividiert durch die Anzahl der Stufen n. Bei einer 4- oder 8-ASK ist m=n, so dass die Anzahl der codierten Bits der Anzahl der Modulationssymbole entspricht. Bei einer 64-QAM kann jedoch m=6 und n=3 sein, so dass die Anzahl der codierten Bits der doppelten Zahl der Modulationssymbole entspricht.

Die so kanalcodierten Daten werden dann im Block 6 Signalraumpunkten zugeordnet, um dann die jeweiligen Modulationssymbole zu erzeugen.

Als die Komponentencodes in den einzelnen Codierern 4 und 5 werden Faltungscodes mit Punktierung verwendet. Somit können die Coderaten aufeinander abgestimmt werden, um eine bestmögliche Übertragungsleistung zu erreichen. Die punktierten Codes weisen eine Periode auf, welche dem Nenner der Coderate entspricht. Beispielsweise hat der Code 4/5 genau fünf Ausgangsbits bei vier Eingangsbits. Die Periode der Ausgangsbits beträgt somit 5, da keine kleinere Anzahl an Ausgangsbits möglich ist, um die Coderate einzuhalten.
Bei der MLC wird für jede Stufe eine andere Coderate verwendet. Um zu gewährleisten, dass die Anzahl der Bits an den Ausgängen aller Codierer 4 und 5 gleich ist, muß diese entsprechend variabel sein. Dies gilt allerdings nur für die Tailbits, denn die Coderate für die Nutzbits bleibt gleich. Durch die Veränderung der Coderate der Tailbits ist es möglich, die Anzahl der Codebits zu beeinflussen. Hierbei geht man von einer maximalen Coderate für die Tailbits aus, welche verringert wird, d.h. es wird zusätzliche Redundanz hinzugefügt, um eine Anpassung zu erreichen. Die Verringerung der Coderate der Tailbits muß dabei für jede Stufe in dem Maß erfolgen, damit in jeder Stufe Ausgangsbits entstehen und diese der Anzahl von Modulationssymbolen multipliziert mit m und dividiert durch n entspricht. Die Anzahl der Tailbits kann über das Punktierungsschema auf jeden Wert in einem gewissen Bereich festgelegt werden. Alternativ kann auch von einer minimalen Coderate ausgegangen werden und diese durch Anpassung der Punktierung vergrößert werden.

Das folgende Beispiel soll den Nutzen verdeutlichen. Bei Verwendung von Faltungscodes mit der Gedächtnislänge 6 werden 6 Tailbits benötigt, um den Codierer 4 oder 5 in einen definierten Endzustand zu überführen. Dieser definierte Endzustand soll für jeden Übertragungsrahmen erreicht werden, um eine Fehlerfortpflanzung beim Dekodieren im Empfänger zu verhindern. Die Tailbits können entweder in den Codierern 4 und 5 oder im Bitmultiplexer 3 ergänzt werden. Als Grundlage dient eine 8-ASK als Modulation mit m=3 und einer MLC mit n=3 Stufen. Werden die Tailbits mit einer Basiscoderate von 2/3 versehen, entstehen genau neun codierte Bits entsprechend den sechs Nullen (Tailbits) am Codierereingang. Hat man 200 Modulationssymbole in einem Übertragungsrahmen ergeben sich idealerweise 200 codierte Bits pro Stufe. Zieht man hiervon die minimale Anzahl von neun Tailbits ab, so ergeben sich 191 codierte Nutzbits als maximal mögliche Anzahl pro Stufe. Wird für jede Stufe die Periode betrachtet, ergibt sich, dass für die Stufe 0 mit einer Coderate von 1/3 genau 189 codierte Bits (entspricht bei der Coderate 63 Nutzbits) entstehen und folglich elf Tailbits benötigt werden. Für die Stufe 1 mit einer Coderate von 2/3 liegen genau 189 codierte Bits (entspricht bei der vorliegenden Coderate 126 Nutzbits) vor, so dass ebenfalls elf Tailbits notwendig sind. In der Stufe 2 sind es 190 codierte Bits mit einer Coderate von 4/5 (entspricht 152 Nutzbits) und es sind somit zehn Tailbits notwendig. Die Coderaten der Tailbits der Stufen werden von der Basiscoderate 2/3 auf 6/11 für die Stufe 0 und die Stufe 1 bzw. 6/10 für die Stufe 2 geändert. Hiermit hat man erreicht, dass alle Modulationssymbole mit codierten Bits belegt sind. Aus dieser Rechnung ergibt sich, dass 341 Nutzbits übertragen werden, was im Vergleich zu herkömmlichen Verfahren einer Kapazitätssteigerung entspricht. Es ergeben sich dabei 568 codierte Bits, die den 341 Nutzbits entsprechen. Bei herkömmlichen Verfahren mit den Coderaten 4/5 und 2/3 wäre es notwendig gewesen, eine Anzahl von codierten Bits und damit von Nutzbits zu wählen, die durch 3 und 5 teilbar ist. Mit der variablen Coderate ist es nun möglich, einen optimalen Wert für die codierten Bits zu erreichen.

In Figur 2 werden dann die so codierten Modulationssymbole von dem Funktionsblock 6 an einen OFDM-Modulator 7 übertragen, der die einzelnen Modulationssymbole auf nahe beieinanderliegende Frequenzträger, die zueinander orthogonal sind, verteilt. Die so entstandenen OFDM-Signale werden dann in einem analogen Hochfrequenzteil 8 gemischt, verstärkt und dann mit einer Antenne 9 ausgestrahlt.

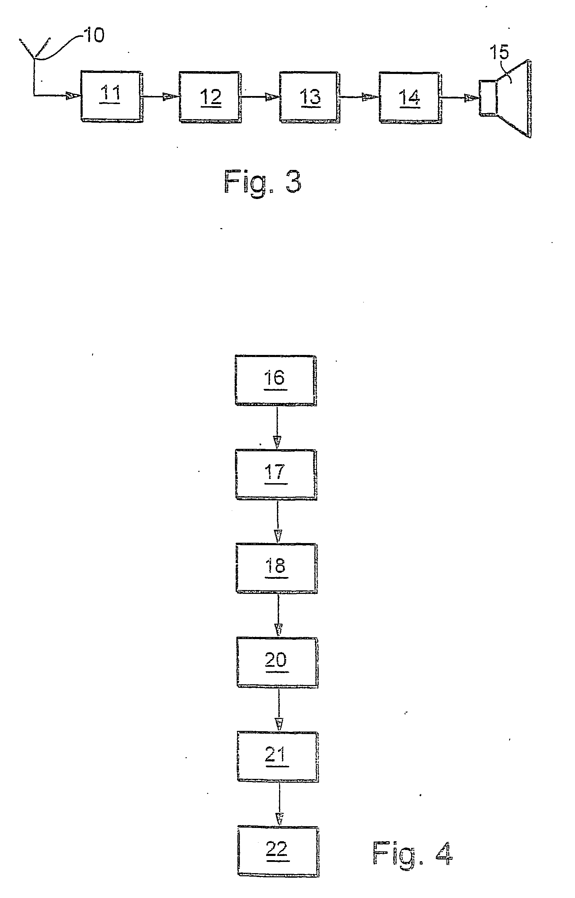

In Figur 3 ist ein Blockschaltbild des erfindungsgemäßen Empfängers dargestellt. Eine Antenne 10 zum Empfang der OFDM-Signale ist an einen Eingang eines Hochfrequenzempfangsteils 11 angeschlossen. Das Hochfrequenzempfangsteil 11 setzt die empfangenen Signale in eine Zwischenfrequenz um, verstärkt und filtert sie. Darüber hinaus überträgt das Hochfrequenzempfangsteil 11 diese Signale an ein Digitalteil 12, der die empfangenen Signale digitalisiert und eine OFDM-Demodulation durchführt. Die so gewonnenen Modulationssymbole werden dann von einem Prozessor 13 demoduliert und in einen Datenstrom überführt, der von dem Prozessor 13 in analoge Signale umgewandelt wird, die dann von dem Audioverstärker 14 verstärkt werden, um schließlich mit dem Lautsprecher 15 wiedergegeben zu werden. Alternativ ist es hier möglich, auch Multimediadaten zu empfangen, die dann optisch wiedergegeben werden. Der Sender signalisiert daneben den Empfängern, wie die feste Coderate für die Kanalcodierung der Nutzbits und die Übertragungsrate ist. Damit ist es dann den Empfängern möglich, die jeweilige variable Coderate für die Tailbits zu bestimmen.

In Figur 4 ist das erfindungsgemäße Verfahren als Flußdiagramm dargestellt. In Verfahrensschritt 16 werden die Daten vom Datenspeicher 1 bereitgestellt und durch den Quellencodierer 2 einer Quellencodierung unterzogen. In Verfahrensschritt 17 wird der so entstandene Datenstrom in parallel verlaufende Datenströme durch den Bitmultiplexer 3 aufgeteilt. In Verfahrensschritt 18 führen die einzelnen Codierer die Kanalcodierung durch, wobei die Nutzbits mit einer festen Coderate codiert werden und die Tailbits mit einer variablen Coderate, die davon abhängt, dass die Anzahl der Ausgangsbits der einzelnen Codierer 4 und 5 mit der Anzahl der Modulationssymbole übereinstimmt. Dies wird durch das sogenannte Punktierungsschema der Tailbits jeder Stufe erreicht. In Verfahrensschritt 20 werden im Funktionsblock 6 den so entstandenen kanalcodierten Daten Signalraumpunkte zugeordnet, um die Modulationssymbole zu erzeugen. In Verfahrensschritt 21 werden die Modulationssymbole einer OFDM-Modulation unterzogen und in Verfahrensschritt 22 erfolgt die Verstärkung bzw. Versendung der OFDM-Signale. Zusätzlich werden hierbei noch die feste Coderate für die Nutzbits und die Übertragungsrate von dem Sender als Signalisierung an die Empfänger übertragen, so dass die Empfänger in der Lage sind, die variablen Coderaten anhand der empfangenen Daten auszurechnen.

## Patentansprüche

1. Verfahren zur codierten Modulation von digitalen Daten, wobei die digitalen Daten Nutzbits aufweisen, wobei die codierte Modulation mehrstufig ausgeführt wird, wobei die Nutzbits für die codierte Modulation in parallele Datenströme aufgeteilt werden, wobei jeder Datenstrom von einem jeweiligen Codierer (4, 5) einer Kanalcodierung unterzogen wird, wobei jeder Datenstrom aus den Nutzbits mit wenigstens einer festen Coderate kanalcodiert wird, **dadurch gekennzeichnet, dass** jeder Datenstrom aus den Nutzbits um Tailbits ergänzt wird, dass die Tailbits in dem jeweiligen Codierer (4, 5) mit einer variablen Coderate kanalcodiert werden, um eine vorgegebene Bitanzahl für den jeweiligen Codierer (4, 5) zu erreichen, wobei die variable Coderate so eingestellt wird, dass eine zur Verfügung stehende Übertragungskapazität, die durch Übertragungsrahmen für Modulationssymbole definiert ist, voll genutzt wird, so dass alle parallel codierten Datenströme dieselbe Anzahl an Bits enthalten und dass die kanalcodierten Daten Signalraumpunkten zugeordnet werden, um die Modulationssymbole zu erzeugen, dass die variable Coderate der Tailbits mittels variabler Punktierung erreicht wird.

2. Verfahren nach Anspruch 1, **dadurch gekennzeichnet, dass** alle möglichen Punktierungsschemata einem Sender und Empfängern bekannt gemacht werden, indem die Punktierungsschemata in einer Tabelle jeweils im Sender und in den Empfängern abgespeichert sind.

3. Verfahren nach Anspruch 1, **dadurch gekennzeichnet, dass** alle möglichen Punktierungsschemata der Tailbits berechnet werden, wobei die Berechnungsmethode einem Sender sowie Empfängern bekannt ist.

4. Verfahren nach Anspruch 2 oder 3, **dadurch gekennzeichnet, dass** die feste Coderate und eine Übertragungsrate den Empfängern signalisiert werden.

5. Verfahren nach einem der vorhergehenden Ansprüche, **dadurch gekennzeichnet, dass** als die Kanalcodierung eine Faltungscodierung verwendet wird.

6. Verfahren nach einem der vorhergehenden Ansprüche, **dadurch gekennzeichnet, dass** die Anzahl der codierten Bits durch die Anzahl der Modulationssymbole multipliziert mit der Stufigkeit m der Modulation und dividiert durch die Stufenanzahl erzeugt wird.

7. Verwendung eines Senders zur Durchführung des Verfahrens nach einem der Ansprüche 1 bis 6.

8. Verwendung eines Empfängers zur Durchführung des Verfahrens nach Anspruch 2, 3, 4, 5 oder 6.

## Claims

1. Method for the encoded modulation of digital data, wherein the digital data have useful bits, wherein the encoded modulation is performed in multiple stages, wherein the useful bits for the encoded modulation are split into parallel data streams, wherein each data stream is subjected to channel encoding by a respective encoder (4, 5), wherein each data stream comprising the useful bits is channel-encoded using at least one fixed code rate, **characterized in that** each data stream comprising the useful bits has tail bits added to it, **in that** the tail bits are channel-encoded in the respective encoder (4, 5) using a variable code rate in order to achieve a prescribed number of bits for the respective encoder (4, 5), the variable code rate being set such that an available transmission capacity, which is defined by transmission frames for modulation symbols, is used in full, so that all parallel-encoded data streams contain the same number of bits, and **in that** the channel-encoded data are assigned to signal space points in order to produce the modulation symbols, the variable code rate for the tail bits being achieved by means of variable puncturing.

2. Method according to Claim 1, **characterized in that** all possible puncturing schemes are disclosed to a transmitter and to receivers by virtue of the puncturing schemes being stored in a table in the transmitter and in the receivers, respectively.

3. Method according to Claim 1, **characterized in that** all possible puncturing schemes for the tail bits are calculated, the method of calculation being known to a transmitter and to receivers.

4. Method according to Claim 2 or 3, **characterized in that** the fixed code rate and a transmission rate are signalled to the receivers.

5. Method according to one of the preceding claims, **characterized in that** the channel encoding used is convolution encoding.

6. Method according to one of the preceding claims, **characterized in that** the number of encoded bits is produced from the number of modulation symbols multiplied by the stepping m of the modulation and divided by the number of steps.

7. Use of a transmitter for carrying out the method according to one of Claims 1 to 6.

8. Use of a receiver for carrying out the method according to Claim 2, 3, 4, 5 or 6.

## Revendications

1. Procédé de modulation codée de données numériques selon lequel les données numériques comportant des bits utiles,
la modulation codée étant effectuée à plusieurs étages,
les bits utiles étant répartis en flux de données parallèles pour la modulation codée,
chaque flux de données est soumis à un codage de canal par un codeur respectif (4, 5),
chaque flux de données de bits utiles est codé en canal avec au moins un taux de codage fixe,
**caractérisé en ce que**
chaque flux de données de bits utiles est complété par des bits de queue,
les bits de queue étant codés en canal avec un taux de codage variable dans le codeur respectif (4, 5) pour atteindre un nombre de bits prévu pour le codeur respectif (4, 5),
le taux de codage variable étant réglé pour utiliser complètement la capacité de transmission disponible, définie par la trame de transmission pour les symboles de modulation, de façon que tous les flux de données en codage parallèle contiennent le même nombre de bits et que les données en codage canal soient associées à des points de signal d'espace pour générer les symboles de modulation,
de façon que le taux de codage variable des bits de queue soit atteint par une ponctuation variable.

2. Procédé selon la revendication 1,
**caractérisé en ce qu'**
on fait connaître tous les schémas de ponctuation possibles à un émetteur et à des récepteurs **en ce que** les schémas de ponctuation sont mémorisés dans un tableau chaque fois dans un émetteur et dans les récepteurs.

3. Procédé selon la revendication 1,
**caractérisé en ce qu'**
on calcule tous les schémas de ponctuation possibles des bits de queue, le procédé de calcul étant connu d'un émetteur et des récepteurs.

4. Procédé selon la revendication 2 ou 3,
**caractérisé en ce que**
le taux de codage fixe et un taux de transmission sont signalés aux récepteurs.

5. Procédé selon l'une des revendications précédentes,
**caractérisé en ce que**
le codage de canal utilise un codage à convolution.

6. Procédé selon l'une des revendications précédentes,
**caractérisé en ce que**
le nombre de bits codés est multiplié par le nombre de symboles de modulation avec un échelonnement (m) de la modulation et on divise par le nombre d'échelons.

7. Utilisation d'un émetteur pour mettre en oeuvre le procédé selon l'une des revendications 1 à 6.

8. Utilisation d'un récepteur pour mettre en oeuvre le procédé selon l'une des revendications 2, 3, 4, 5 ou 6.
